# EUROPÄISCHE PATENTSCHRIFT

(11) **EP 2 433 309 B1**
(45) Veröffentlichungstag und Bekanntmachung des Hinweises auf die Patenterteilung: **19.04.2023**
(21) Anmeldenummer: 10745131.2
(22) Anmeldetag: 17.05.2010
(51) Int. Cl.: H01L 31/05, H01L 31/0465, H01L 31/046

(54) **ANORDNUNG UND VERSCHALTUNG, SOWIE VERFAHREN ZUR VERSCHALTUNG VON FLÄCHENARTIGEN SOLARZELLEN**
ARRANGEMENT AND CIRCUIT, AND METHOD FOR INTERCONNECTING FLAT SOLAR CELLS
AGENCEMENT ET INTERCONNEXION DE CELLULES SOLAIRES PLANES AINSI QUE PROCÉDÉ D'INTERCONNEXION DESDITES CELLULES

(30) Priorität: 18.05.2009 DE 102009025828; 17.05.2010 DE 102010016975
(43) Veröffentlichungstag der Anmeldung: 28.03.2012
(73) Patentinhaber: Markus Hörmann Vermietungen und Verpachtungen, 89281 Altenstadt (DE)
(72) Erfinder: MÜNCH, Markus, 01640 Coswig (DE); TEGEN, Stefan, 01127 Dresden (DE)
(74) Vertreter: Hecht, Jan-David
(86) Internationale Anmeldenummer: PCT/DE2010/075040
(87) Internationale Veröffentlichungsnummer: WO 2010/133224

(56) Entgegenhaltungen:
- EP-A2- 2 058 870
- DE-A1- 4 030 713
- JP-A- 2005 191 479
- US-A1- 2003 121 228
- US-A1- 2005 268 959

## Beschreibung

Die Erfindung betrifft eine Anordnung und eine Verschaltung sowie Verfahren zur Verschaltung von flächenartigen starren oder flexiblen Solarzellen, deren photoelektrisch aktiven Schichten, auf einem isolierenden Substratmaterial aufgebracht sind, insbesondere für Dünnschichtsolarzellen nach den übergriffen der Ansprüche eins, zwei, drei und zwölf. Flächige Solarzellen in Dünnschichttechnologie können sowohl starr als auch flexibel ausgebildet sein. Ebenso können diese Solarzellen auch einzelne, diskrete Solarzellen, aber auch mehrere, sogenannte monolithisch verschaltete Solarzellen auf einem gemeinsamen Substratmaterial sein.

Der positive und negative Kontakt einer Solarzelle kann sich auch auf der gleichen Seite der Solarzelle befinden (das betrifft neben den hier beschriebenen Solarzellen beispielsweise auch klassische Silizium-Rückseitenkontaktzellen). Bei der Verschaltung von einzelnen Solarzellen zu einer Solarzellenmatrix werden nach dem heutigen Stand der Technik die einzelnen Solarzellen mit einem definierten Abstand angeordnet und mit speziellen Kontaktelementen (Leitungsverbindern) oder Flachleitern untereinander elektrisch kontaktiert, wie aus der US 020050268959 und der DE 10 2006 019 638 A1 ersichtlich. Die Anordnung mit definierten Abständen zwischen den einzelnen Solarzellen dient dabei der Prozesssicherung, damit es während der Herstellung und während des Betriebes nicht zu Kurzschlüssen an den Solarzellenkanten bedingt durch die Berührung der Solarzellen untereinander kommt. Dadurch entsteht, insbesondere bei kleinen Solarzellenabmessungen, ein nicht unerheblicher Anteil inaktiver Fläche bezogen auf die Fläche eine Solarzellenmatrix auf einem Solarmodul, der nicht zur Absorption des Sonnenlichts und zur Energiewandlung genutzt werden kann. Weiterhin ist bei der Verschaltung der einzelnen Solarzellen darauf zu achten, dass bei den dem Stand der Technik entsprechenden Solarzellenanordnungen an den Solarzellenkanten keine Kurzschlüsse durch Verbindungsmaterialien wie beispielsweise einzelne beschädigte oder ungenau angeordnete Verbinder, Lot, Lotpasten, Leitkleber oder Leitpasten entstehen, die zum Ausfall der entsprechenden Solarzellen und letztlich zu einer erheblichen Leistungsminderung einer aus einer Vielzahl von Solarzellen bestehenden Solarzellenmatrix oder eines gesamten Solarmoduls führen können.

Weiterhin weist der optisch nicht aktive, aber für die Verschaltung der Solarzellen unabdingbare Rückseitenkontaktbereich (bei vorderseitig kontaktierbaren Solarzellen) einen relativ hohen Flächenanteil an der inaktiven, nicht zur Energieumwandlung dienenden Solarzellenoberfläche auf. Es sind eine Reihe von verschiedenen technischen Lösungen für solcherart Solarzellenanordnungen bekannt, um diese untereinander optimal mit wenig Flächenverlust der aktiven Fläche zu verschalten. Aus der DE 37 08 548 A1 ist ein Solarzellenmodul mit parallel und seriell angeordneten Solarzellen bekannt, wobei das Problem der optimalen Verschaltung dadurch gelöst wird, dass benachbarte Solarzellenzeilen überlappend und gegeneinander versetzt so angeordnet sind, dass die Solarzellen in einer Serien/Parallelschaltung untereinander verschaltet sind. Dabei wird die Rückseite einer Solarzellenzeile jeweils mit der Vorderseite der nächsten Solarzellenseite verschaltet. Der Nachteil dieser Lösung besteht darin, dass in einem Zwischenschritt eine Lötpaste ausgebracht werden muss, danach die nächste Zeile der Solarzellen genau positioniert und aufgelegt werden muss und danach das Verlöten mittels eines thermischen Verfahrens vorgenommen werden muss. Dabei dürfen sich die Solarzellen bei der Handhabung gegeneinander keinesfalls verschieben. Der wesentlichste Nachteil dürfte aber sein das jeweils immer nur eine Solarzellenzeile nach der anderen auf ein Grundmaterial aufgelegt werden kann und dann jeweils die Kontaktmaterialien aufgebracht werden müssen, bevor die nächste Solarzellenzeile aufgelegt werden kann.

Es ist weiterhin eine Vielzahl von unterschiedlichen gestalteten Leitungsverbindungen für die Verbindung von einzelnen Solarzellen untereinander bekannt. So ist in DE 102 35 048 A1 ein Solarzellenverbinder mit einer Ausgleichssektion beschrieben, wobei die Ausgleichssektion eine rahmenförmige Struktur besitzt und innerhalb der rahmenförmigen Struktur eine Ausnehmung angeordnet ist. Durch die geschlossene Rahmenstruktur sollen Spannungsspitzen im Material verhindert werden. Allerdings ist dieser konstruktive Aufbau mechanisch fest ausgelegt und es sind bei dieser Konstruktion trotzt der mittigen Ausnehmung keinerlei federnde Eigenschaften einzelner Teile möglich und zudem verlangt diese technische Lösung einen erheblichen Platzbedarf zur Verschaltung der einzelnen Solarzellen untereinander, da die einzelnen benachbarten Solarzellen jeweils definiert voneinander beabstandet angeordnet werden müssen.

Aus der EP 1 126 558 A2 ist ein besonders federnder, von der Seite aus betrachtet, z-förmiger Solarzellenverbinder bekannt, der eine feingliedrige Struktur besitzt. Seine Konstruktion ist allerdings relativ aufwendig und er überschreitet in der Höhe die obere Kante der untereinander zu verbinden Solarzellen, d. h. das Einbettungsmaterial muss an dieser Stelle zusätzlich weiter ausgespart sein. Deshalb benötigt dieser Solarzellenverbinder um seine volle Wirksamkeit zu erreichen einen besonders großen Platzbedarf. Die Herstellung eines solchen Solarzellenverbinders ist zudem relativ aufwändig und seine automatisierte Installation einschließlich der Kontaktierung mit den Kontaktflächen der Solarzellen ist nur schwer beherrschbar.

Die EP 1 037 309 A2 beschreibt einen anderen flachbauenden Solarzellenverbinder, der gleichfalls federnde Eigenschaften haben soll. Allerdings treten an den Kontaktstellen zwischen den Kontaktflächen der Solarzelle und den Kontaktflächen der Solarzellenverbinder Torsionskräfte auf, da die Solarzellenverbinder relativ breit ausgebildet sind und federnde Eigenschaften eher nicht zu erwarten sind. Auch dieser Solarzellenverbinder minimiert die Materialspannungen nur unerheblich und es kann nach relativ kurzer Einsatzzeit bei großen Temperaturschwankungen zu einem Abreißen der Kontakte kommen. Auch hier ist der Platzbedarf zur Verschaltung benachbarter Solarzellen, wie bei den bereits aufgeführten technischen Lösungen erheblich.

Die JP 2001-30999 A beschreibt einen weiteren einfachen gekrümmten Solarzellenverbinder für einen Raumflugkörper, der wiederum über die obere Grenzfläche der einzelnen Solarzellen hinaus ragt. Insofern gelten für diese Ausführung ebenfalls die gleichen Nachteile, wie für die vorstehend aufgeführten Schriften.

In der JP 2005-191479 A wird ein massiv ausgebildeter flacher bandartiger Solarzellenverbinder beschrieben, der sich über die gesamte Breite des Schlitzes, der zwischen zwei benachbarten Solarzellen ausgebildet ist, erstreckt. Dieser Solarzellenverbinder besitzt ebenfalls keinerlei federnde Eigenschaften. Um überhaupt eine dauerhafte Gewährleistung der Kontaktierung zu ermöglichen, ist er sehr breit ausgeführt und besitzt relativ viele Kontaktstellen mit den zu kontaktierenden Kontaktflächen der einzelnen jeweils benachbarten Solarzellen. Er kann sowohl zur Verbindung zweier Vorderseiten (Vorder-Vorderseitenkontakt) oder auch zur Verbindung eines Vorder-Rückseitenkontaktes von benachbarten Solarzellen eingesetzt werden. Aber bei dieser Ausführung wird bei längerer Zug- und Druckbelastung die Elastizitätsgrenze des Leitungsverbindungsmaterials ebenfalls überschritten, so das es zur Zerstörung der Kontaktierung kommen kann.

*In der technischen Lösung gemäß der* EP 2 058 870 A2 *ist eine Kontaktierung und eine Modulverschaltung von Dünnschichtsolarzellen auf polymeren Trägern beschrieben, in der auf der Rückseite der Dünnschichtsolarzellen Durchbrüche durch die polymere Trägerfolie angeordnet sind, welche mit leitfähigen Verbindungsmitteln ausgefüllt sind, die Elektrodenkontaktpunkte darstellen und die mit Elektroden weiterer Dünnschichtsolarzellen parallel oder in Reihe geschaltet sind. Dabei sind die Durchbrüche nur rückseitig angeordnet und es ist nur eine begrenzte Kontaktierung mit relativ weiten Überlappung der einzelne Solarzellen zu einem Modulverbund möglich.*

Aufgabe der Erfindung ist es, eine neuartige Anordnung und Verschaltung sowie ein zugehöriges Verfahren zur Verschaltung von flächenartigen Solarzellen, deren photoelektrisch aktiven Schichten, einschließlich der Kontakte, auf einem isolierenden Substratmaterial aufgebracht sind, zu schaffen, die das Kurzschlussrisiko und die inaktive Fläche im Solarzellen-Matrixverbund oder einem Solarmodul zuverlässig verringert, die wahlweise eine leicht variierbare einfache Verschaltung sowohl als Reihenschaltung als auch als Serienschaltung ermöglicht und den Herstellungsprozess sowohl der Verschaltung als auch den gesamten Herstellungsprozess von Solarzellenmodulen aus einer Vielzahl von einzelnen untereinander kontaktierten Solarzellen vereinfacht und beschleunigt.

Erfindungsgemäß wird die Aufgabe mit den technischen Merkmalen des ersten und neunten Patentanspruches gelöst. Vorteilhafte Ausgestaltungen des Hauptanspruches sind Bestandteil der abhängigen Unteransprüche. Bei der erfindungsgemäßen Anordnung und Verschaltung von flächigen starren oder flexiblen Solarzellen, deren photoelektrisch aktiven Schichten, einschließlich der Kontakte, auf einem isolierenden Substratmaterial 2 aufgebracht sind, deren positive und negative Kontakte auf einer Seite, ausschließlich auf einer Seite der Fläche und/oder auf einer Seite der Fläche und an einer bzw. mehreren Stirnseiten angeordnet sind, sind die Solarzellen 1 im Kontaktbereich mit einer oder mehreren benachbarten Solarzellen 1, wie an sich bereits bekannt, überlappend angeordnet.

Diese Solarzellen 1 sind in neuartiger Art und Weise mit einem Kontaktmaterial 10 am Überlappungsbereich untereinander einmal oder mehrmals mit Kontaktmaterial 10 oder Schaltpunkten 22 direkt verschaltet, wobei das Kontaktmaterial das isolierende Substrat überbrückt. Diese Schaltpunkte können von der Form her geometrisch beliebig ausgeformt sein und beispielsweise auch kreisförmige, quadratische oder rechteckige Grundflächen aufweisen.

Besonders geeignet ist die Erfindung bei Dünnschicht-Solarzellen, welche auf einem isolierenden Substratmaterial aufgebracht sind, wie zum Beispiel solche auf der Basis von amorphen und/oder mikrokristallinem Silizium, organischen Verbindungen, Farbstoffen, Kadmiumtellurid, Kupfer-Indium-Diselenid, Kupfer-Indium-Gallium-Diselenid, Kupfer-Indium-Diselenid, Kupfer-Indium-Sulfid oder anderen III-V-Halbleitern. Dabei erfolgt das Verschalten ausschließlich nur auf einer Vorderseite 18 oder nur auf einer Rückseite 19 oder zwischen den Stirnseiten 20 oder zwischen einer oder mehreren Stirnseiten 20 und einer Vorderseite 18 bzw. Rückseite 19.

Mit Hilfe des erfindungsgemäßen Verfahrens zur Verschaltung von flächigen Solarzellen und zur Kontaktherstellung zu den Sammelleitern zur Stromableitung wird auf einer gesamten Solarzellenmatrix aus mehreren überlappenden Solarzellen 1 an einzelnen oder bei Bedarf wahlweise auch an mehreren (gegebenenfalls auch vielzahligen) Schaltpunkten 22 jeweils eine elektrisch leitfähige Schicht mittels Siebdruck, Dispensieren, Aufsprühen, Bedampfen, Sputtern oder galvanischem Abscheiden erzeugt. Diese Schicht bzw. die entsprechende Anzahl Schichten werden dann punktuell an den entsprechenden Stellen so aufgebracht, dass jeweils der Rückseitenkontakt 7 der oberen Solarzelle 1 mit dem Frontseitenkontakt 17 der überlappten unmittelbar benachbarten Solarzelle 1 verbunden wird. Entscheidend für die Ausführung des Kontaktes ist die Anordnung der Kontakte auf der Solarzelle 1. In dem Fall, wo sowohl der Frontseitenkontakt 17 als auch der Rückseitenkontakt 7 jeweils auf der Vorderseite der Solarzelle 1 angeordnet sind, ist das Kontaktmaterial 10 so aufgebracht, dass dieses vom Rückseitenkontakt 7 über die Stirnseite der Solarzelle hinweg bis auf den Frontseitenkontakt 17 der überlappten nächsten benachbarten Solarzelle 1 reicht. Ist der Rückseitenkontakt 7 allerdings seitlich an einer Stirnseite 20 der Solarzelle 1 angeordnet, kann das Kontaktmaterial nur an den entsprechenden Stellen von der Stirnseite aus bis auf den Frontseitenkontakt 17 der nächsten Solarzelle 1 angeordnet sein. Das Kontaktmaterial 10 kann hier als durchgehender Strang oder als einzelner oder mehrfacher Kontakt in einem oder mehreren Schaltpunkten 22 aufgebracht und angeordnet sein. Die Schichtdicken und Schichtbreiten des Kontaktmaterials 10 des am jeweiligem Schaltpunkt 22 oder den Schaltpunkten 22 aufgebrachten Kontaktmaterials sind abhängig von der Dimensionierung der einzelnen zu verbindenden Solarzellen 1, deren jeweils erzeugten und abzuleitenden Strömen und der Materialzusammensetzung des eingesetzten Kontaktmaterials 10. Es ist auch möglich, anstelle der vorstehend beschriebenen Aufbringung des Kontaktmaterials 10 auf die gesamte Zellenmatrix, dieses auch durch Auflegen vorgefertigter Kontaktmaterialien 10 (z. B. Auflegen von Kontaktelementen) als Schaltverbindungen an den jeweiligen Schaltpunkten 22, verbunden mit einem anschließenden Fixieren, anzuordnen.

Dadurch wird eine zuverlässige dauerhafte und mechanisch stabile Verschaltung von sich überlappenden Solarzellen möglich. Der Vorteil der erfindungsgemäßen Anordnungen und des entsprechenden Verfahrens gegenüber den aus dem Stand der Technik bekannten Anordnungen liegt darin, dass die inaktive Fläche im Matrixverbund eines Solarmoduls mit der erfindungsgemäßen Anordnung und den damit verbundenen Überlappungen erheblich minimiert werden kann. Die lichtabsorbierende Fläche kann mit dieser erfindungsgemäßen Lösung bis zu 10 Prozent vergrößert werden.

Um verschiedene Verschaltungen von flächigen Solarzellen 1 herstellen zu können, ist es sinnvoll, die einzelnen zu verschaltenden überlappenden Solarzellen 1 gegeneinander linear versetzt anzuordnen und zu verschalten.

Dabei können die einzelnen zu verschaltenden überlappenden Solarzellen 1 gegeneinander linear je nach Anwendungsfall und gewünschter Anordnung um einen Wert zwischen 1 bis 99 % in bezug auf die Zellenlänge 12 versetzt angeordnet und verschaltet sein. Entscheidend für die minimale Überlappung ist die Anordnung und Größe des erforderlichen Schaltpunktes 22. Der Vorteil besteht in einer besseren Verschattungstoleranz bei einzelnen, miteinander verschalteten Solarzellen 1. Theoretisch kann der Abstand der einzelnen zu verbindenden Solarzellen auch größer sein, allerdings sind dann besonders lange Leitungsverbinder oder lange Streifen von Kontaktmaterial zur Verschaltung untereinander erforderlich.

Bei einer besonders bevorzugen Anordnung zur Verschaltung von flächigen Solarzellen 1 sind die einzelnen zu verschaltenden überlappenden Solarzellen 1 gegeneinander bezogen auf Ihre Abmessungen genau hälftig linear versetzt angeordnet und verschaltet. Dabei können die auftretenden Querströme gleichmäßiger verteilt werden.

Es ist auch generell eine Anordnung zur Verschaltung von flächigen Solarzellen denkbar, bei der die einzelnen zu verschaltenden überlappenden Solarzellen 1 in den Abmessungen unterschiedlich groß ausgebildet und bezogen auf die Abmessungen linear versetzt angeordnet sind. Um die vorhandene Fläche auf dem Trägermaterial optimal auszunutzen können, sind des Weiteren zusätzlich flächig kleinere Solarzellen an den Rändern eines aus einer Vielzahl von überlappenden Solarzellen 1 bestehenden Solarmoduls angeordnet und verschaltet. Dadurch können zum einen sehr variierbare Verschaltungsvarianten der Solarzellen 1 eines Solarmoduls mit einer optimalen Flächenbelegung und damit maximierten Leistungsabgabe verbunden werden.

Durch die erfindungsgemäße Lösung wird es auch erstmals möglich, neuartige Anordnung zur Verschaltung von flächigen Solarzellen herzustellen und zum Einsatz zu bringen, wobei die einzelnen zu verschaltenden überlappenden Solarzellen 1 oder Solarzellenanordnungen gegeneinander versetzt und voneinander innerhalb einer Reihe beabstandet im Sinne eines Schachbrettmusters angeordnet und verschaltet sind. Denkbar sind auch andere geometrische Anordnungen und Formen wie beispielsweise Schriftzeichen, Symbole oder Zahlen.

Eine weitere neuartige Anordnung zur Verschaltung von flächigen Solarzellen kann hergestellt werden, indem die einzelnen zu verschaltenden überlappenden Solarzellen 1 rechtwinklig zueinander versetzt in Sinne eines Parkettmusters angeordnet und untereinander erfindungsgemäß verschaltet sind.

In einer besonderen Ausführung der erfindungsgemäßen Lösung können die einzelnen zu verschaltenden überlappenden Solarzellen 1 auf einer ein- oder zweidimensional konvex und/oder konkav gekrümmten Oberfläche eines Trägermaterials oder auch sogar auf einer Zylinderfläche angeordnet und verschaltet sein. Damit lassen sich solcherart Solarzellen auch auf bislang nicht geeignet erscheinenden Oberflächen und Oberflächenformen anbringen. So ist es nunmehr z. B. möglich Solarzellen auch problemlos auf zylindrischen Oberflächen oder anderweitig gekrümmten sich bewegenden Oberflächen, d. h. die kontinuierlich oder auch diskontinuierlich mit Licht beaufschlagt werden, aufzubringen. Mit erfindungsgemäßen Solarzellen-Matrixverbünden oder entsprechend bestückten Solarmodulen können völlig neue Aufbringungsflächen erschlossen werden.

In Abhängigkeit von der Lage und Anordnung der untereinander zu kontaktierenden Solarzellenkontakte kann das Verfahren zur Verschaltung von flächigen Solarzellen so modifiziert werden, dass das Verschalten der überlappenden Solarzellen 1 entweder nur auf der Vorderseite 18, oder nur auf der Rückseite 19 der Solarzellen 1, oder zwischen den Stirnseiten 20, oder zwischen einer oder mehreren Stirnseiten 20 und einer Vorder- bzw. Rückseite 18, 19, oder der Innenseite einer Öffnung 21 und einer Vorder- bzw. Rückseite 18, 19 erfolgen.

Vorteilhaft ist es, wenn beim Verfahren zur Verschaltung von flächigen Solarzellen auf die gesamte Zellenmatrix aus mehreren überlappenden Solarzellen 1 an den Schaltpunkten 22 die elektrisch leitfähigen Schichten, die die Kontaktierung herstellen, mittels Siebdruck, Dispensieren, Aufsprühen, Bedampfen, Sputtern oder galvanischen Abscheidens gleichzeitig in einem einzigen Arbeitschritt erzeugt werden oder wenn in einer anderen Ausführung des Verfahrens auf die gesamte Zellenmatrix an den Schaltpunkten 22 die Kontaktmaterialien 10 gleichzeitig in einem einzigen Arbeitsschritt aufgelegt und fixiert werden.

Verfahrensgemäß können auch beim Verschalten von flächigen Solarzellen auf die gesamte Zellenmatrix aus mehreren überlappenden Solarzellen 1 an den Schaltpunkten 22 die zur Kontaktierung dienenden elektrisch leitfähigen Kontaktmaterialien mit Hilfe einer Kombination zweier oder mehrerer Verfahren, wie mittels Siebdruck und/oder Dispensieren und/oder Aufsprühen und/oder Bedampfen und/oder Sputtern und/oder galvanischen Abscheidens auf die gesamte Zellenmatrix an den Schaltpunkten 22 die Kontaktmaterialen 10 aufgelegt und fixiert werden.

In einem speziellen, besonders vorteilhaften und zeitlich effektiven Verfahren zur Verschaltung von flächigen Solarzellen kann gleichzeitig, d. h in einem Verfahrensschritt, eine gesamte Metallisierung der Zellenmatrix, der positiven Solarzellenkontakte 4, der negativen Solarzellenkontakte 5, der Kontaktfinger 6 und der Verschaltung des Solarmoduls nach der Anordnung und Fixierung der überlappenden Solarzellen 1 auf dem Trägermaterial (z. B. auf einem Rückseitenglas) erfolgen.

Besonders günstig beim erfindungsgemäßen Verfahren zur Verschaltung von flächigen Solarzellen 1 ist es, wenn das aufzubringende Kontaktmaterial 10 zum Verschalten der überlappenden Solarzellen 1 untereinander das gleiche Material ist, wie das Material zur Solarzellenmetallisierung als auch die gesamte andere Verschaltung des Solarmoduls (d. h. das Kontaktmaterial 10 an den Schaltpunkten 22).

Bei der erfindungsgemäßen Anordnung und dem entsprechenden Verfahren wird das Kurzschlussrisiko zuverlässig reduziert, da der positive Kontakt im Verschaltungsbereich sowohl die Oberflächen der Solarzellen als auch die Zellenkanten im Matrixverbund umfasst. Insbesondere ist auch eine dauerhafte und schnell herzustellende Verschaltung mit nur einfachen Materialien wie z. B. Leitpasten und/oder Leitkleber o.ä. durch Aufdrucken oder Dispensieren bzw. Bedampfen möglich. Dies bedeutet als Vorteil den Wegfall der bisherigen als Zusatzteile einzubringenden Leitungsverbinder in der Art von Verbinderbändchen / -stanzteile o.ä.

Als weiterer Verfahrensvorteil kann die Zellenmetallisierung und Verschaltung im Prinzip in einem einzigen Fertigungsschritt nahezu gleichzeitig realisiert werden. Bei nur auf einer Seite kontaktierten Solarzellen, d. h. der Rückseitenkontakt ist auf die Vorderseite der Solarzelle geführt, kann der Kontaktierungsgraben 8 im Bereich des positiven Solarzellenkontaktes 4 komplett wegfallen, da die Zellenvorderseite mit der Metallisierung über das Verbindermaterial an der Kante der Solarzelle kurzgeschlossen wird. Dies hat zur Folge, dass die Breite des Rückseitenkontaktbereiches auf der Zellenoberfläche noch weiter reduziert und der Isolationsgraben 9 näher an der Zellenkante positioniert werden kann. Als ein weiterer erheblicher Vorteil des erfindungsgemäßen Verfahrens ist die problemlose Herstellung sowohl von reinen Serienschaltungen als auch Serien-Parallel-Schaltungen der einzelnen Solarzellen untereinander zu nennen. Serien-Parallelschaltungen haben den Vorteil, dass durch das Fließen von Querströmen die Verschattungstoleranz verbessert werden kann. Dies resultiert in einem geringeren Leistungsverlust bei Teilverschattungen und verbessert das sogenannte Hot-Spot-Verhalten der Solarzellenverschaltung. Zusätzlich eröffnet das erfindungsgemäße Verfahren die Möglichkeit, die gesamte Metallisierung der Solarzellenmatrix (Busbars, Kontaktfinger und Verschaltung) erst nach der Anordnung der Solarzellen auf das Trägermaterial in einem einzigen Verfahrensschritt aufbringen zu können.

Die erfindungsgemäße neuartige Anordnung und das zugehörige Verfahren zur Verschaltung von flächenartigen Solarzellen verringert das Kurzschlussrisiko zuverlässig. Die inaktive Fläche im Solarzellen-Matrixverbund oder einem Solarmodul kann erheblich verringert werden was die Leistungsausbeute erhöht. Zudem kann je nach Bedarf die Verschaltung problemlos als sowohl als Reihenschaltung als auch als Serienschaltung als auch als Reihen-Parallelschaltung an den jeweils gewünschten Anwendungsfall angepasst werden. Insgesamt wird der Herstellungsprozess eines Solarzellen-Matrixverbundes, der Verschaltungsprozess und auch der Herstellungsprozess von großflächigen Solarzellenmodulen aus einer Vielzahl von einzelnen untereinander kontaktierten Solarzellen vereinfacht und beschleunigt.

Die Erfindung soll nachstehend an Hand der Figuren 1 bis 14 in verschiedenen Ausführungsvarianten näher erläutert werden.
- Figur 1: zeigt eine Draufsicht auf eine flächige diskrete Solarzelle 1
- Figur 2: zeigt einen seitlichen Schnitt durch eine flächige diskrete Solarzelle 1
- Figur 3: zeigt eine Schnittdarstellung dreier benachbarter sich überlappender Solarzellen 1 mit Sammelleitern 14 auf der Vorderseite 18
- Figur 4: zeigt eine Schnittdarstellung dreier benachbarter sich überlappender Solarzellen 1 mit Sammelleitern 14 auf der Vorderseite 18 und stirnseitiger Kontaktierung
- Figur 5: zeigt eine Draufsicht von vier nebeneinander überlappend angeordneten und verschalteten Solarzellen 1 mit jeweils neun Schaltpunkten 22 pro Solarzelle 1
- Figur 6: zeigt eine Draufsicht von acht nebeneinander überlappend und versetzt angeordneten und verschalteten Solarzellen 1 mit jeweils neun Schaltpunkten 22 pro Solarzelle 1
- Figur 7: zeigt eine Draufsicht auf eine Solarzellenmatrix mit vier Reihen von nebeneinander liegenden, versetzt überlappenden und verschalteten Solarzellen 1
- Figur 8: zeigt eine Anordnung von vier Reihen von Solarzellen 1 mit einem sehr großen Abstand 15 zwischen zwei Solarzellen 1 innerhalb einer Reihe
- Figur 9: zeigt eine Draufsicht auf einen Solarzellen-Matrixverbund in einer Reihen-Parallel-Verschaltung gruppierter Solarzelle 1
- Figur 10: zeigt eine Anordnung von Solarzellen 1 in einer Art Parkettmuster einschließlich deren Verschaltung untereinander
- Figur 11: zeigt eine Anordnung von strahlenförmig nach außen angeordneten Solarzellen 1 mit nur minimaler Überlappung und mit Kontaktmaterial 10 nur an jeweils einem Schaltpunkt 22 pro Solarzelle 1
- Figur 12: zeigt eine versetzt überlappende Anordnung von vier Solarzellen 1 auf einer konvex gekrümmten Oberfläche eines gewölbten Trägermaterials 16
- Figur 13: zeigt eine Schnittdarstellung von auf der Oberfläche eines Zylinders angeordneten Solarzellen die in der Tiefe sich überlappen
- Figur 14: zeigt eine Schnittdarstellung dreier benachbarter sich überlappender Solarzellen 1 mit erfindungsgemäßen Öffnungen 21 und in diese Öffnungen 21 eingebrachten Kontaktmaterial 10 und freigelegter Rückseitenkontaktfläche 24

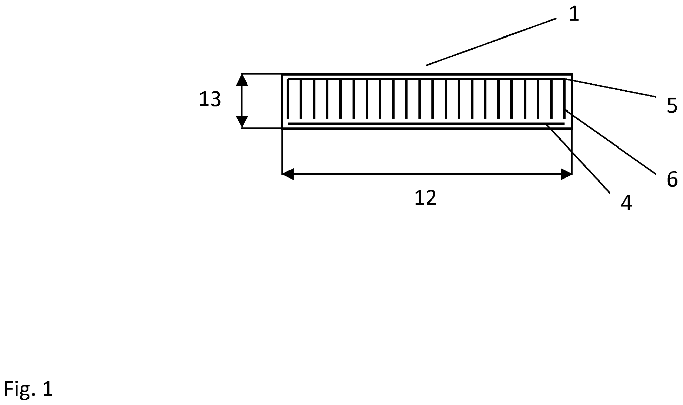

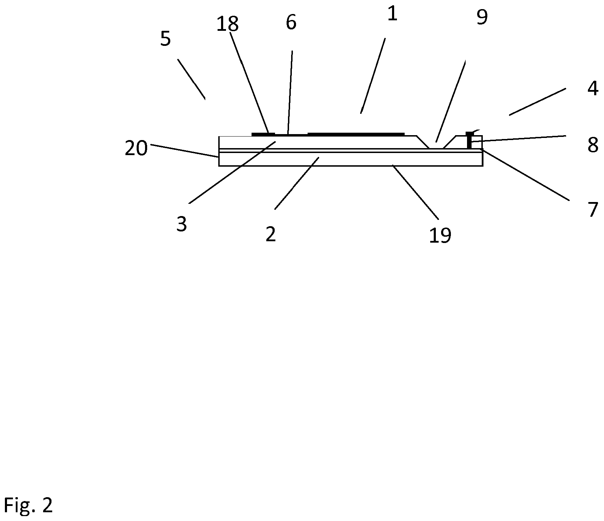

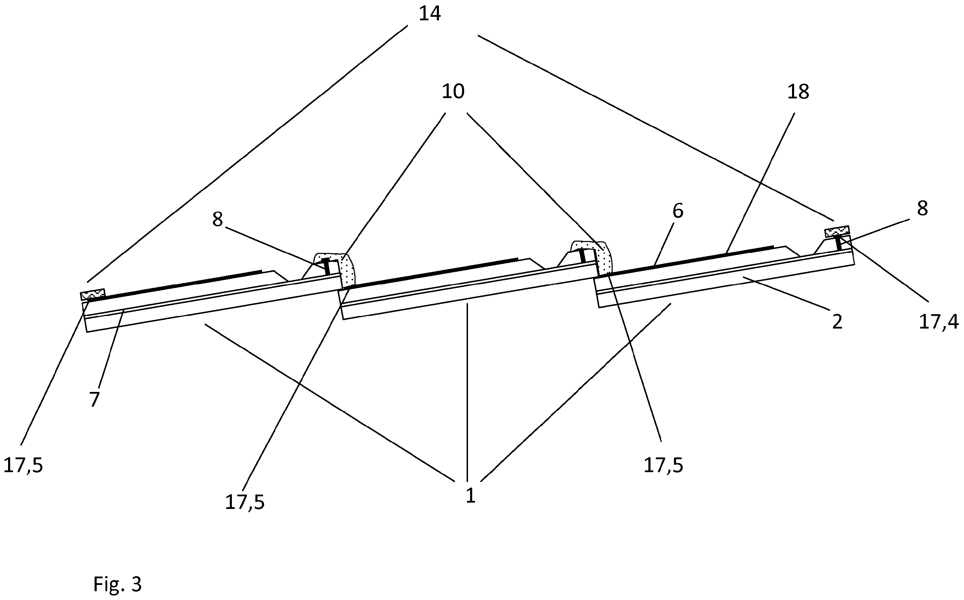

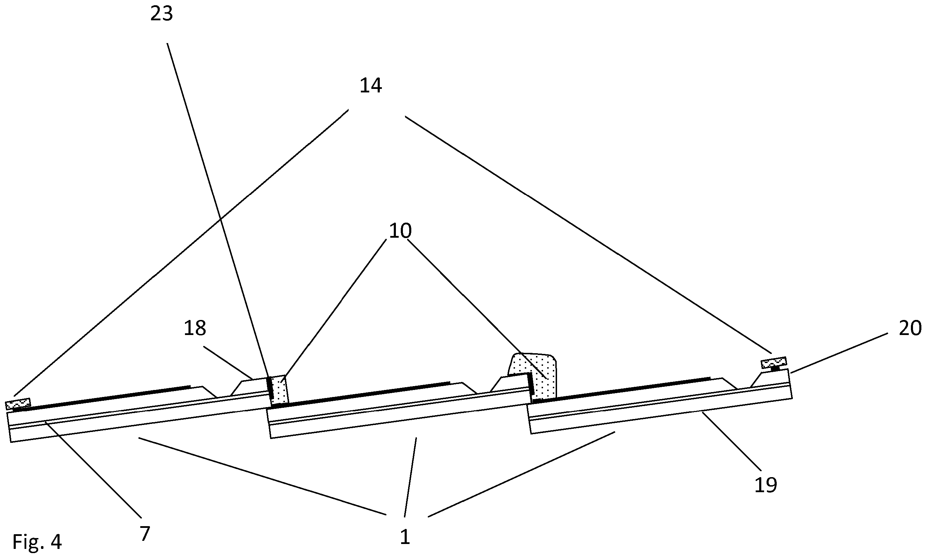

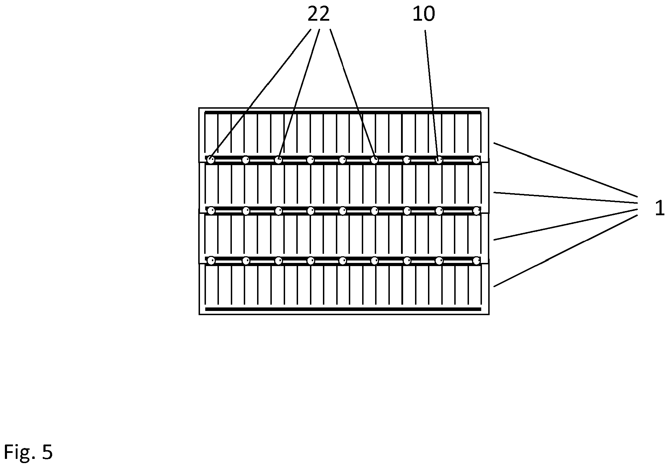

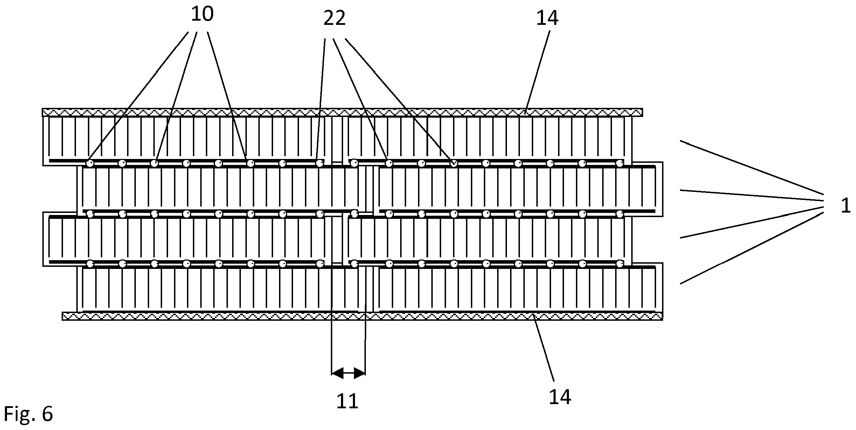

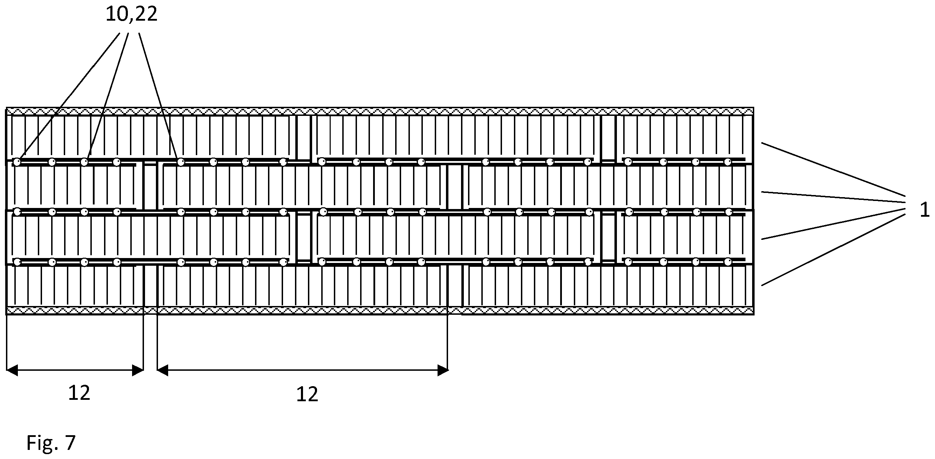

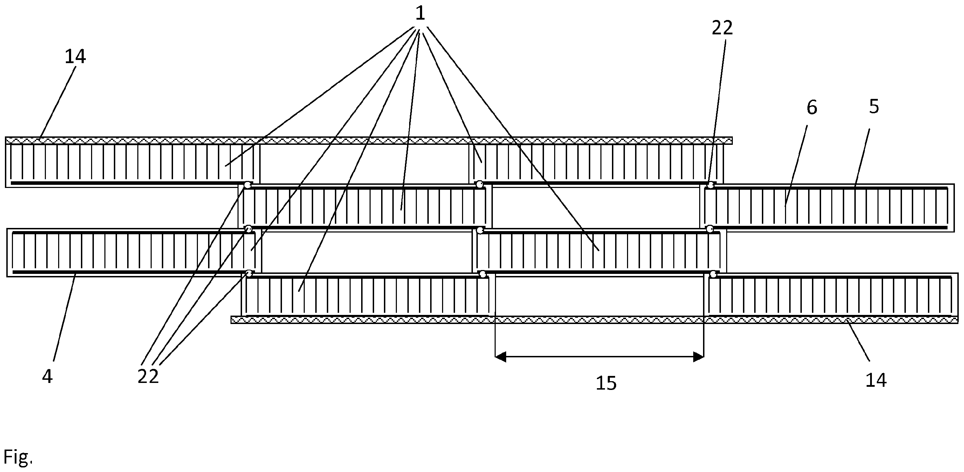

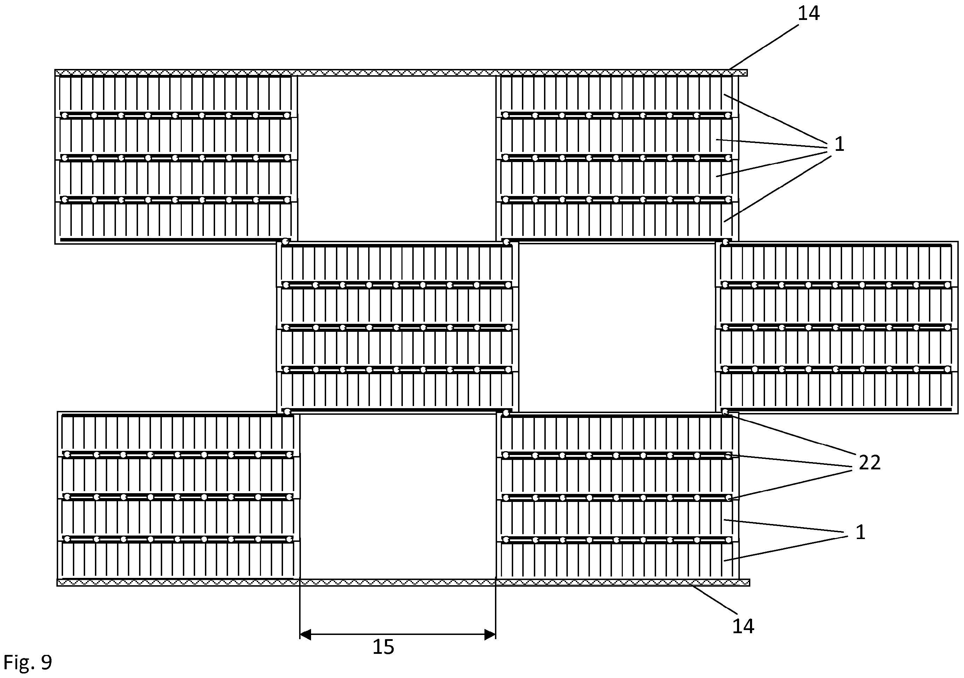

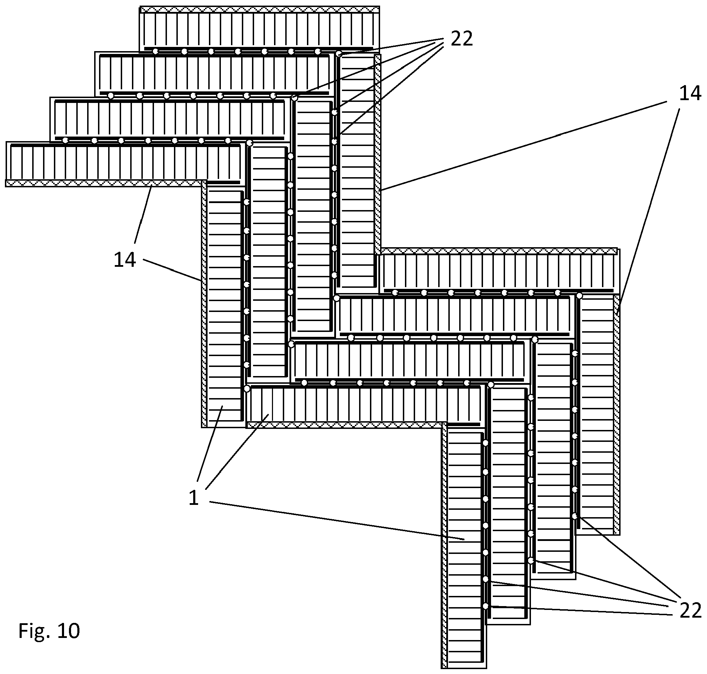

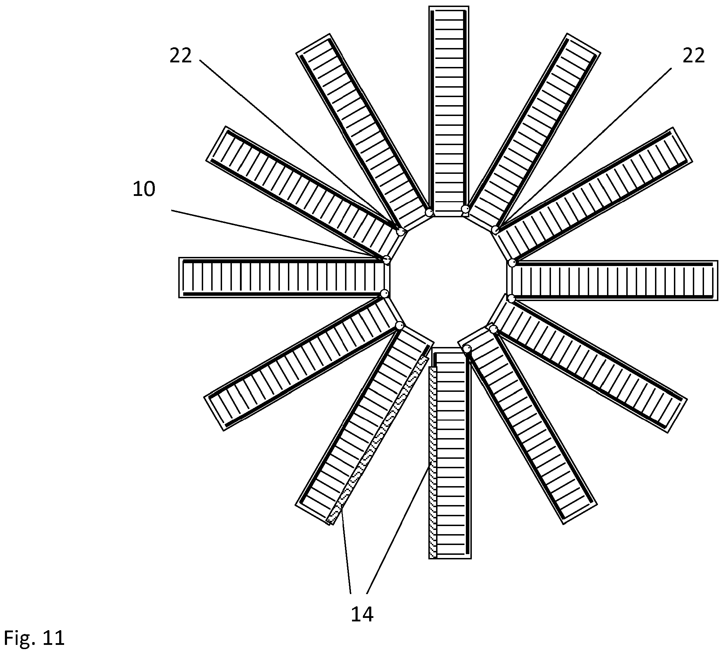

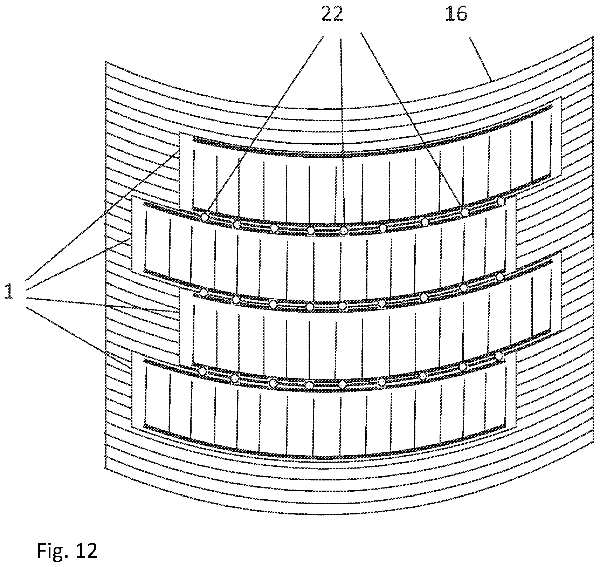

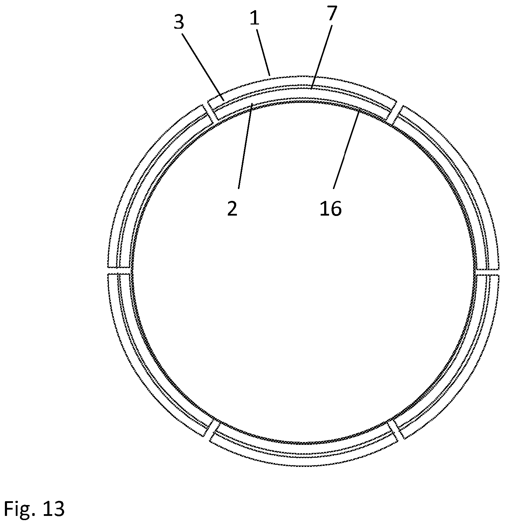

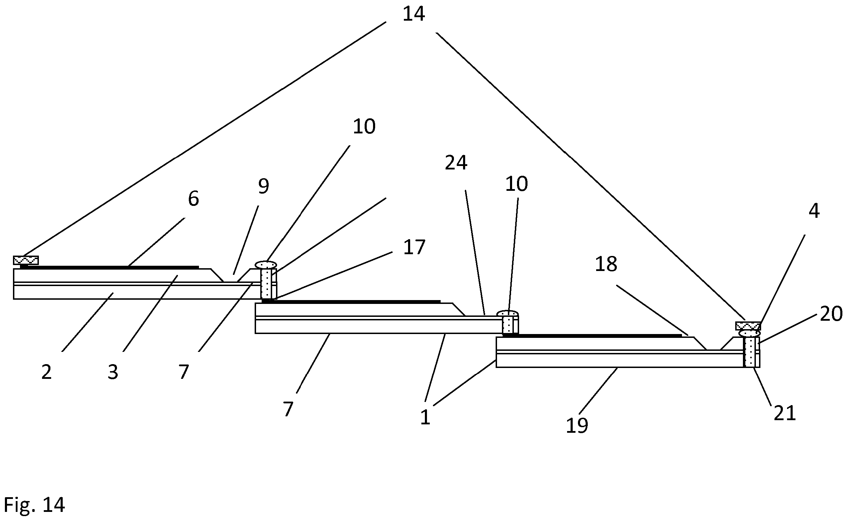

Aus der Draufsicht gemäß Figur 1 und aus der Querschnittsdarstellung gemäß Figur 2 ist ein bevorzugter Aufbau einer flächigen Solarzelle 1, und zwar einer Kupfer-Indium-Gallium-Diselenid-Dünnschicht-Solarzelle mit reinen Vorderseitenkontakten und isolierendem Substrat dargestellt, d. h. beide Kontakte 4 und 5 befinden sich auf der Oberfläche der Vorderseite 18, zu sehen. In der Regel ist die Zellenlänge 12 ein Vielfaches der Zellenbreite 13. Entlang der langen Seite der Solarzelle 1 ist der positive Solarzellenkontakt 4 auf der Vorderseite 18 angeordnet. Dieser positive Solarzellenkontakt 4 ist mit dem Rückseitenkontakt 7, der sich zwischen der Absorberschicht 3 und dem Substratmaterial 2 befindet, mittels einer Kontaktierung im Kontaktierungsgraben 8 leitend verbunden. Auf der Vorderseite 18 ist entlang der anderen langen Seite der negative Solarzellenkontakt 5 angeordnet, der die einzelnen quer liegenden Kontaktfinger 6 verbindet, die den erzeugten Strom aus der aktiven Absorberfläche sammeln und dem negativen Solarzellenkontakt 5 zuleiten. Neben dem negativen Solarzellenkontakt 5 ist in der Absorberschicht 3 der Isolationsgraben 9 eingebracht, der die Absorberschicht an dieser Stelle trennt, um Kurzschlüsse zwischen den Enden der Kontaktfinger 6 und dem negativen Solarzellenkontakt 5 zu verhindern. Der Isolationsgraben 9 kann dabei bis auf die Oberfläche des Rückseitenkontaktes 7 geführt sein. Die Fläche des Substratmaterials 2 ist gleich groß wie die Fläche, die das Material, das die aktive Absorberschicht 3 bildet, so dass eine flächige Stirnseite 20 entsteht. Die Rückseite 19 des Substratmaterials 2 ist bevorzugt mit einer zusätzlichen Kleberschicht (in der Zeichnung nicht dargestellt) versehen. Dadurch ist es möglich, die einzelne Solarzelle 1 beim Anordnen auf einem Trägermaterial sofort genau und unverrückbar zu fixieren. In Figur 3 ist eine Schnittdarstellung dreier benachbarter sich überlappender Solarzellen 1 mit Sammelleitern 14 auf der Vorderseite 18 gezeigt. Der positive Solarzellenkontakt 4, der als Frontseitenkontakt 17 ausgeführt ist, ist mittels Kontakten 10 zum Vorderseitenkontakt 17,5 leitend verbunden. Dabei ist der positive Solarzellenkontakt 4 mittels Kontaktmaterial 10 mit dem negativen Solarzellenkontakt 5 so verbunden, dass das Kontaktmaterial 10 sowohl den positiven Solarzellenkontakt 4 als auch den negativen Solarzellenkontakt 5 überdeckt. Dabei ist das Kontaktmaterial über die komplette Stirnseite 20 geführt. Praktisch ist der positive Solarzellenkontakt 4 an der Stirnseite 20 ein zweites Mal leitend angeschlossen, was die Sicherheit der Verbindung weiter erhöht. Das Kontaktmaterial 10 kann, je nach Bedarf, als kleinflächiger Schaltpunkt oder auch wahlweise als eine Art durchgehender Schaltstreifen aufgebracht und ausgehärtet werden. Zur Abführung des erzeugten Stromes von den, hier aus drei Reihen von hintereinander angeordneten Solarzellen 1 bestehenden Solarzellen-Matrixverbundes, sind jeweils links und rechts außen auf den Frontseitenkontakten 17 die Sammelleiter 14 angeordnet, d. h. ein positiver und ein negativer Solarzellenkontakt 4 und 5 sind variabel anschließbar zur Stromabführung nach außerhalb des Solarzellen-Matrixverbundes. Eine andere Ausführungsform der erfindungsgemäßen Kontaktierung 10 ist in Figur 4 dargestellt. Diese zeigt eine Schnittdarstellung dreier benachbarter sich überlappender Solarzellen 1 mit Sammelleitern 14 auf der Vorderseite 18, und im Gegensatz zu vorher nunmehr mit stirnseitiger Kontaktierung bei Anordnung von reinen Stirnseitenkontakten 23 für den Rückseitenkontakt 7. Das Kontaktmaterial 10 kann dabei wahlweise entweder nur von dem Stirnseitenkotakt 23 zum Frontseitenkontakt 17 des negativen Solarzellenkontaktes 5 aufgelegt und ausgehärtet sein oder übergreift die Stirnseite 20 ganz und überdeckt noch teilweise die Oberfläche des nicht aktiven Absorbermaterials auf der Verschaltungsseite der Solarzelle 1. In Figur 5 ist eine Draufsicht von vier hintereinander überlappend angeordneten und verschalteten Solarzellen 1 mit jeweils neun Schaltpunkten 22 pro Solarzelle 1 abgebildet, so dass ein Solarzellen-Matrixverbund aus vier Solarzellen 1 entsteht. Das Kontaktmaterial 10 ist hierbei punktartig entlang der Verschaltungsseite verteilt aufgebracht und ausgehärtet, wobei eine definierte Anzahl von einzelnen voneinander beabstandeten Schaltpunkten 22 gebildet wird. Die Anzahl der Schaltpunkte 22 ist dabei von der Dimensionierung der einzelnen Solarzellen 1 und dem jeweils erzeugten Strom abhängig. Aus Sicherheitsgründen ist es sinnvoll, jeweils mehrere Schaltpunkte 22 pro Überlappung anzuordnen, damit, bei eventuellen Abreißen oder schlechter Kontaktierung von ein oder zwei Schaltpunkten 22, die anderen noch für einen funktionierenden Stromfluss sorgen können und jede einzelne Solarzelle 1 Leistung erzeugen kann. Figur 6 zeigt eine Draufsicht von acht nebeneinander überlappend und zudem mit einem geringen Versatz 11 versetzt angeordneten und verschalteten Solarzellen 1 mit jeweils neun Schaltpunkten 22 pro Solarzelle 1, so dass ein Solarzellen-Matrixverbund aus acht Solarzellen mit einer Reihen-Parallelverschaltung entsteht. Hier ist auch die Anordnung der beiden erforderlichen Sammelleiter 14 mit gezeigt, an denen der erzeugte Strom nach außen abgeführt werden kann. Die Abbildung gemäß Figur 7 zeigt eine Draufsicht auf eine mögliche Solarzellenmatrix mit vier Reihen von nebeneinander liegenden, hälftig versetzt überlappenden und verschalteten Solarzellen 1, wobei vier Solarzellen eine kürzere Zellenlänge 12 besitzen, mit punktförmig angeordnetem Kontaktmaterial 10, so dass pro langer Solarzelle 1 acht Schaltpunkte 22 und pro kurzer Solarzelle 1 vier Schaltpunkte 22 ausgebildet sind. Im Ergebnis entsteht ein rechteckiger Solarzellen-Matrixverbund aus acht großen langen und vier kurzen, praktisch halblangen Solarzellen 1. Eine andere Ausführung der verschiedenen Verschaltungsmöglichkeiten ist in Figur 8 dargestellt, wo eine Anordnung von vier Reihen von Solarzellen 1 mit einem sehr großen Abstand 15 (größer als 90 Prozent der Zellenlänge 12) zwischen zwei Solarzellen 1 innerhalb einer Reihe eines Solarzellen-Matrixverbundes gezeigt ist und wobei die extrem versetzt angeordneten einzelnen Solarzellen jeweils mit nur einem Schaltpunkt 22 pro positivem bzw. negativem Solarzellenkontakt 4 bzw. 5 angeordnet sind. Dadurch kann eine höhere Lichtdurchlässigkeit eingestellt werden. Die Sammelleiter 14 sind dabei durchgehend aufgelegt und ausgebildet. Die lichtdurchlässige Fläche kann in einem breiten Bereich beliebig variiert werden. In Figur 9 ist eine andere Möglichkeit gezeigt, wie die Lichtdurchlässigkeit ebenfalls variiert werden kann. Dabei sind jeweils vier Solarzellen 1 gruppiert und in Reihe untereinander verschaltet und mehrere Solarzellengruppen sind zu einem Solarzellen-Matrixverbund als eine Reihen-Parallelschaltung verbunden. Es ist auch denkbar und möglich die Anordnung einzelner Solarzellen 1 nach Figur 8 mit einer Anordnung in Solarzellengruppen nach Figur 9 zu verbinden. Neben Einstellung jeder beliebigen Lichtdurchlässigkeit können hier auch verschiedene gestaltete optische Muster erzeugt werden. Zudem besteht die Möglichkeit, an bestimmten Stellen eine größere Fläche klar durchscheinend zu gestalten und damit eine Art Fenster zu erzeugen. Eine völlig andere Anordnung von Solarzellen 1 in einer Art Parkettmuster ist in Figur 10 dargestellt. Auch hier sind die einzelnen Solarzellen 1 teilweise überlappend angeordnet und wie bereits mehrfach beschrieben untereinander mit einer bestimmten Anzahl von Schaltpunkten 22 verschaltet. Die Sammelleiter 14 sind dabei teilweise unterbrochen um Kurzschlüsse entlang der Zellenbreite 13 zuverlässig zu vermeiden. Die Kontaktierung mittels Kontaktmaterial 10 erfolgt dabei so, dass alle einzelnen, rechtwinklig zueinander als eine Art Parkettmuster versetz angeordneten Solarzellen 1 untereinander als eine spezielle Reihen-Parallelschaltung verschaltet sind. Dadurch können unterschiedliche unkonventionelle neuartige optische Erscheinungsbilder von Solarzellenanordnungen erzeugt werden. Generell sind durch die erfindungsgemäße Lösung völlig neuartige bislang überhaupt nicht mögliche Solarzellenanordnungen herstellbar. Als Beispiel hierfür soll die Anordnung gemäß Figur 11 gelten, welche eine Anordnung von strahlenförmig nach außen angeordneten Solarzellen 1 zeigt, wo nur eine minimale Überlappung und mit der Konzentration des Kontaktmaterials 10 nur an bzw. in jeweils einem Schaltpunkt 22 pro Solarzelle 1 die Verschaltung realisiert werden kann. In Figur 12 ist eine versetzt überlappende Anordnung von vier Solarzellen 1 auf einer konvex gekrümmten Oberfläche eines gewölbten Trägermaterials 16 abgebildet. Auch solche Anwendungen auf gekrümmten Oberflächen sind mit der erfindungsgemäßen Anordnung und der Herstellung mit dem erfindungsgemäßen Verfahren problemlos realisierbar. Auch eine Anordnung auf Oberflächen von Zylindern ist möglich, wie Figur 13 zeigt. In dieser beispielhaften Schnittdarstellung sind sechs Solarzellen 1 auf ein zylindrisches Trägermaterial 16 aufgelegt und positioniert. Die Überlappung der verschalteten Solarzellen ist hier nicht dargestellt, da sie sich entlang der Tiefe überlappen und erfindungsgemäß an den Überlappungsstellen wie bereits vorstehend mehrfach beschrieben, untereinander in Reihen-Parallelschaltung verschaltet sind. Eine andere Ausführung ist in einer Schnittdarstellung in Figur 14 gezeigt. Hierbei überlappen sich zum Beispiel drei benachbarte Solarzellen 1. In diese überlappenden Solarzellen sind erfindungsgemäß in neuartiger Art und Weise im Randstreifen der sich rechts neben dem Isolationsgraben 9 befindet, eine oder wahlweise mehrere durchgehende Öffnungen 21 eingebracht. Diese Öffnungen 21 durchdringen das Absorbermaterial 2, den Rückseitenkontakt 7, d. h. den positiven Solarzellenkontakt 4 und das Substratmaterial 2. Sie reichen bis zur Rückseite 19 der Solarzelle 1. Alternativ können im Bereich der Öffnungen 21 die photoelektrisch aktiven Schichten ausschließlich des auf dem isolierenden Substratmaterial befindlichen Rückseitenkontaktes entfernt oder gar nicht erst aufgetragen werden. Dadurch entstehen freigelegte Rückseitenkontaktflächen 24 auf der Solarzellenvorderseite 18. Die Öffnungen 21 durchdringen dann ausschließlich das Substratmaterial 2 und den Rückseitenkontakt 7. Dadurch muss der Rückseitenkontakt 7 nicht nach oben auf die Vorderseite 18 als Frontseitenkontakt 17 oder seitlich nach außen an die Stirnseite 20 als Stirnseitenkontakt 23 geführt sein. Der Rückseitenkontakt 7 liegt innerhalb der und/oder um die Öffnung 21 so frei, dass dieser mittels des Kontaktmaterials 10 elektrisch leitend verbunden werden kann. An und/oder in den Öffnungen 21 wird mittels Kontaktmaterial 10 eine elektrische Verbindung zwischen Rückseitenkontakt 7 und den unmittelbar darunter liegenden einen oder mehreren Frontseitenkontakten 17 der benachbarten Solarzellen 1 praktisch als eine Art Schaltstift geschaltet. Vorteilhaft an dieser Verschaltung ist, dass die Isolationsgräben 9 um die Schaltpunkte 22 herumbeführt werden können, so dass die Licht umwandelnde Fläche der Solarzelle erheblich vergrößert wird. Eine weitere Vergrößerung dieser Fläche kann erreicht werden, indem die Absorberschicht 3 um die Schaltpunkte 22 herum entfernt oder gar nicht erst aufgebracht wird, und der entlang einer Solarzellenseite verlaufende, durchgehend ausgebildete Isolationsgraben 9 somit unnötig wird.

### Liste der Bezugszeichen

- 1: Solarzelle
- 2: Substratmaterial
- 3: Absorberschicht
- 4: Positiver Solarzellenkontakt
- 5: Negativer Solarzellenkontakt
- 6: Kontaktfinger
- 7: Rückseitenkontakt
- 8: Kontaktierungsgraben mit Kontaktierung des positiven Solarzellenkontakts zum Rückseitenkontakt
- 9: Isolationsgraben
- 10: Kontaktmaterial
- 11: Versatz
- 12: Solarzellenlänge
- 13: Solarzellenbreite
- 14: Sammelleiter
- 15: Abstand in Längsrichtung
- 16: Gewölbtes Trägermaterial
- 17: Frontseitenkontakt
- 18: Vorderseite
- 19: Rückseite
- 20: Stirnseite
- 21: Öffnungen
- 22: Schaltpunkt
- 23: Stirnseitenkontakt
- 24: freigelegte Rückseitenkontaktfläche

## Patentansprüche

1. Anordnung und Verschaltung von flächigen starren oder flexiblen Solarzellen, deren photoelektrisch aktiven Schichten auf einem isolierenden Substratmaterial aufgebracht sind,
deren positive und negative Kontakte auf einer Seite, ausschließlich auf einer Seite der Fläche und/oder auf einer Seite der Fläche und an einer oder mehreren Stirnseiten angeordnet sind,
wobei die Solarzellen (1) im Kontaktbereich mit einer oder mehreren benachbarten Solarzellen (1) überlappend angeordnet sind,
wobei die Solarzellen (1) mit einem Kontaktmaterial (10) am Überlappungsbereich untereinander einmal oder mehrmals verschaltet sind,
wobei das Kontaktmaterial das isolierende Substrat überbrückt und
das Verschalten ausschließlich nur auf einer Vorderseite (18) oder nur auf einer Rückseite (19) oder zwischen den Stirnseiten (20) oder zwischen einer oder mehreren Stirnseiten (20) und einer Vorder- oder Rückseite (18, 19) erfolgt.

2. Anordnung und Verschattung von flächigen starren oder flexiblen Solarzellen nach Anspruch 1,
wobei die einzelnen zu verschaltenden überlappenden Solarzellen (1) gegeneinander linear versetzt angeordnet und verschaltet sind.

3. Anordnung und Verschattung von flächigen starren oder flexiblen Solarzellen nach Anspruch 2,
wobei die einzelnen zu verschaltenden überlappenden Solarzellen (1) gegeneinander linear um einen Wert zwischen 1 bis 99 % in bezug auf die Zellenlänge (12) versetzt angeordnet und verschaltet sind.

4. Anordnung und Verschaltung von flächigen starren oder flexiblen Solarzellen nach Anspruch 2,
wobei die einzelnen zu verschaltenden überlappenden Solarzellen (1) gegeneinander bezogen auf ihre Abmessungen genau hälftig linear versetzt angeordnet und verschaltet sind.

5. Anordnung und Verschaltung von flächigen starren oder flexiblen Solarzellen nach Anspruch 2,
wobei die einzelnen zu verschaltenden überlappenden Solarzellen (1) in den Abmessungen unterschiedlich groß ausgebildet und bezogen auf die Abmessungen linear versetzt angeordnet sind und zusätzlich flächig kleinere Solarzellen an den Rändern eines aus einer Vielzahl von überlappenden Solarzellen (1) bestehenden Solarmoduls angeordnet und verschaltet sind.

6. Anordnung und Verschaltung von flächigen starren oder flexiblen Solarzellen nach Anspruch 2,
wobei die einzelnen zu verschaltenden überlappenden Solarzellen (1) oder Solarzellenanordnungen gegeneinander versetzt und voneinander innerhalb einer Reihe beabstandet im Sinne eines Schachbrettmusters angeordnet und verschaltet sind.

7. Anordnung und Verschaltung von flächigen starren oder flexiblen Solarzellen nach Anspruch 2,
wobei die einzelnen zu verschaltenden überlappenden Solarzellen (1) rechtwinklig zueinander versetzt in Sinne eines Parkettmusters angeordnet und untereinander verschaltet sind.

8. Anordnung und Verschaltung von flächigen starren oder flexiblen Solarzellen nach Anspruch 2,
wobei die einzelnen zu verschaltenden überlappenden Solarzellen (1) auf einer ein- oder zweidimensional konvex und/oder konkav gekrümmten Oberfläche eines gekrümmten Trägermaterials oder auf einer Zylinderfläche angeordnet und verschaltet sind.

9. Verfahren zur Verschaltung von flächigen starren oder flexiblen Solarzellen und zur Kontaktherstellung zu den Sammelleitern zur Stromableitung,
dass auf eine gesamte Solarzellenmatrix aus mehreren überlappenden Solarzellen (1) an einzelnen oder mehreren (vielzahligen) Schaltpunkten (22) elektrisch leitfähige Schichten mittels Siebdruck, Dispensieren, Aufsprühen, Bedampfen, Sputtern oder galvanischen Abscheiden erzeugt werden oder
dass auf die gesamte Solarzellenmatrix an den Schaltpunkten (22) Kontaktmaterial (10) aufgelegt und fixiert wird,
wobei das Verschalten der überlappenden Solarzellen (1) nur auf der Vorderseite (18) oder nur auf der Rückseite (19) der Solarzellen oder zwischen den Stirnseiten (20) oder zwischen einer oder mehreren Stirnseiten (20) und einer Vorder- oder Rückseite (18, 19) oder an und/oder in einer Öffnung (21) und einer Vorder- oder Rückseite (18, 19) erfolgt.

10. Verfahren zur Verschaltung von flächigen starren oder flexiblen Solarzellen nach Anspruch 9,
wobei auf die gesamte Solarzellenmatrix aus mehreren überlappenden Solarzellen (1) an den Schaltpunkten (22) elektrisch leitfähige Schichten mittels Siebdruck, Dispensieren, Aufsprühen, Bedampfen, Sputtern oder galvanischen Abscheiden gleichzeitig in einem einzigen Arbeitsschritt erzeugt werden oder
dass auf die gesamte Solarzellenmatrix an den Schaltpunkten (22) die Kontaktmaterialien (10) gleichzeitig in einem einzigen Arbeitsschritt aufgelegt und fixiert werden.

11. Verfahren zur Verschaltung von flächigen starren oder flexiblen Solarzellen nach Anspruch 9,
wobei auf die gesamte Solarzellenmatrix aus mehreren überlappenden Solarzellen (1) an den Schaltpunkten (22) elektrisch leitfähige Schichten mit Hilfe einer Kombination zweier oder mehrere Verfahren, wie mittels Siebdruck und/oder Dispensieren und/oder Aufsprühen und/oder Bedampfen und/oder Sputtern und/oder galvanischen Abscheiden auf die gesamte Zellenmatrix an den Schaltpunkten (22) die Kontaktmaterialen (10) aufgelegt und fixiert werden.

12. Verfahren zur Verschaltung von flächigen starren oder flexiblen Solarzellen nach Anspruch 9,
wobei gleichzeitig in einem Verfahrensschritt eine gesamte Metallisierung der Zellenmatrix des Solarmoduls (der Busbars, der Kontaktfinger und der Verschaltung) nach der Anordnung und Fixierung der überlappenden Solarzellen (1) auf dem Trägermaterial (2) erfolgt.

13. Verfahren zur Verschaltung von flächigen starren oder flexiblen Solarzellen nach einem der Verfahrensansprüche 9 bis 12,
wobei das Kontaktmaterial (10) zum Verschalten der überlappenden Solarzellen (1) untereinander das gleiche Material ist, wie das Material zur Solarzellenmetallisierung.

## Claims

1. Arrangement and interconnection of planar, rigid or flexible solar cells, the photoelectrically active layers of which are applied to an insulating substrate material, the positive and negative contacts of which are arranged on one side, exclusively on one side of the surface and / or on one side of the surface and on one or more end faces,
wherein the solar cells (1) are arranged in an overlapping manner with one or more adjacent solar cells (1) in the contact area,
wherein the solar cells (1) are connected to one another once or several times with a contact material (10) in the overlapping area,
wherein the contact material bridges the insulating substrate and the interconnection only is made on a front side (18) or only on a rear side (19) or between the end faces (20) or between one or more end faces (20) and a front or rear side (18, 19).

2. Arrangement and interconnection of planar, rigid or flexible solar cells according to claim 1,
wherein the individual overlapping solar cells (1) to be interconnected are arranged and interconnected linearly offset to one another.

3. Arrangement and interconnection of planar, rigid or flexible solar cells according to claim 2,
wherein the individual overlapping solar cells (1) to be interconnected are arranged and interconnected linearly offset to one another by a value between 1 to 99% with respect to the cell length (12).

4. Arrangement and interconnection of planar, rigid or flexible solar cells according to claim 2,
wherein the individual overlapping solar cells (1) to be interconnected are arranged and interconnected linearly offset to one another by exactly the half with respect to their dimensions.

5. Arrangement and interconnection of planar, rigid or flexible solar cells according to claim 2,
wherein the individual overlapping solar cells (1) to be interconnected are of different sizes and are arranged linearly offset in relation to the dimensions and, in addition, planar, smaller solar cells are arranged and interconnected at the edges of a solar module consisting of a plurality of overlapping solar cells (1).

6. Arrangement and interconnection of planar, rigid or flexible solar cells according to claim 2,
wherein the individual overlapping solar cells (1) or solar cell arrangements to be interconnected are arranged and interconnected offset from one another and spaced apart from one another within a row in the sense of a checkerboard pattern.

7. Arrangement and interconnection of planar, rigid or flexible solar cells according to Claim 2,
wherein the individual overlapping solar cells (1) to be interconnected are arranged and connected offset at right angles to one another in the sense of a parquet pattern.

8. Arrangement and interconnection of planar, rigid or flexible solar cells according to claim 2,
wherein the individual overlapping solar cells (1) to be interconnected are arranged and interconnected on a one-dimensionally or two-dimensionally convex and/or concave curved surface of a curved carrier material or on a cylinder surface.

9. Method for interconnecting planar, rigid or flexible solar cells and for making contact with the busbars for the collection of current,
that electrically conductive layers are applied to an entire solar cell matrix made up of multiple overlapping solar cells (1) at one or more (multiple) switching points (22) by means of screen printing, dispensing , Spraying, vapor deposition, sputtering or galvanic deposition or
that contact material (10) is placed and fixed on the entire solar cell matrix at the switching points (22),
wherein the overlapping solar cells (1) are connected only on the front side (18) or only on the rear side (19) of the solar cells or between the end faces (20) or between one or more end faces (20) and a front or rear side (18, 19) or at and/or in an opening (21) and a front or rear side (18, 19).

10. Method for connecting planar rigid or flexible solar cells according to claim 9, wherein electrically conductive layers are applied to the entire solar cell matrix made up of a number of overlapping solar cells (1) at the switching points (22) by means of screen printing, dispensing, spraying, vapor deposition, sputtering or galvanic deposition simultaneously in a single step or
that the contact materials are applied and fixed on the entire solar cell matrix at the switching points (22) simultaneously in a single step.

11. Method for interconnecting planar, rigid or flexible solar cells according to claim 9,
wherein electrically conductive layers are applied to the entire solar cell matrix of multiple overlapping solar cells (1) at the switching points (22) using a combination of two or more methods such as screen printing and/or dispensing and/or spraying and/or vapor deposition and/or sputtering and / or galvanic deposition, the contact materials (10) are placed and fixed on the entire cell matrix at the switching points (22).

12. Method for interconnecting planar, rigid or flexible solar cells according to claim 9, wherein simultaneously in one method step an entire metallization of the cell matrix of the solar module (the busbars, the contact fingers and the interconnection) is carried out after the arrangement and fixing of the overlapping solar cells (1) on the carrier material (2).

13. Method for interconnecting planar, rigid or flexible solar cells according to one of the preceding method claims 9 - 12, wherein the contact material (10) for interconnecting the overlapping solar cells (1) among one another is the same material as the material for the solar cell metallization.

## Revendications

1. Ensemble et interconnexion de cellules solaires rigides ou flexibles planes, dont les couches actives photo-électriquement sont appliquées sur un matériau de substrat isolant, dont les contacts positifs et négatifs sont disposés sur un côté, exclusivement sur un côté de la surface et/ou sur un côté de la surface et sur un ou plusieurs côtés frontaux,
dans lequel et laquelle les cellules solaires (1) sont disposées de manière à chevaucher une ou plusieurs cellules solaires (1) adjacentes dans la zone de contact,
dans lequel et laquelle les cellules solaires (1) sont interconnectées entre elles une fois ou à maintes reprises sur la zone de chevauchement dans un matériau de contact (10),
dans lequel et laquelle le matériau de contact surmonte le substrat isolant et l'interconnexion a lieu exclusivement sur un côté avant (18) ou seulement sur un côté arrière (19) ou entre les côtés frontaux (20) ou entre un ou plusieurs côtés frontaux (20) et un côté avant ou un côté arrière (18, 19).

2. Ensemble et interconnexion de cellule solaires rigides ou flexibles planes selon la revendication 1,
dans lequel et laquelle les diverses cellules solaires (1) se chevauchant à interconnecter sont disposées et interconnectées de manière décalée linéairement les unes par rapport aux autres.

3. Ensemble et interconnexion de cellules solaires rigides ou flexibles planes selon la revendication 2,
dans lequel et laquelle les diverses cellules solaires (1) se chevauchant à interconnecter sont disposées et interconnectées de manière décalée linéairement les unes à l'encontre des autres d'une valeur entre 1 à 99 % par rapport à la longueur de cellule (12).

4. Ensemble et interconnexion de cellules solaires rigides ou flexibles planes selon la revendication 2,
dans lequel et laquelle les diverses cellules solaires (1) se chevauchant à interconnecter sont disposées et interconnectées de manière décalée linéairement précisément de moitié par rapport à leurs dimensions les unes à l'encontre des autres.

5. Ensemble et interconnexion de cellules solaires rigides ou flexibles planes selon la revendication 2,
dans lequel et laquelle les diverses cellules solaires (1) se chevauchant à interconnecter sont réalisées avec des dimensions présentant des valeurs différentes et sont disposées de manière décalée linéairement par rapport à leurs dimensions et des cellules solaires planes de plus petite taille sont disposées et interconnectées en supplément sur les bords d'un module solaire constitué d'une pluralité de cellules solaires (1) se chevauchant.

6. Ensemble et interconnexion de cellules solaires rigides ou flexibles planes selon la revendication 2,
dans lequel et laquelle les diverses cellules solaires (1) les divers ensembles de cellules solaires se chevauchant à interconnecter sont disposés et interconnectés de manière décalée les uns à l'encontre des autres et de manière espacée les uns des autres au sein d'une rangée au sens d'un motif en damier.

7. Ensemble et interconnexion de cellules solaires rigides ou flexibles planes selon la revendication 2,
dans lequel et laquelle les diverses cellules solaires (1) se chevauchant à interconnecter sont disposées de manière décalée à angle droit les unes par rapport aux autres au sens d'un motif de parquet.

8. Ensemble et interconnexion de cellules solaires rigides ou flexibles planes selon la revendication 2,
dans lequel et laquelle les diverses cellules solaires (1) se chevauchant à interconnecter sont disposées et interconnectées sur une surface incurvée de manière convexe et/ou concave sur le plan mono- ou bidimensionnel d'un matériau de support incurvé ou sur une surface cylindrique.

9. Procédé d'interconnexion de cellules solaires rigides ou flexibles planes et d'établissement de contact avec des barres omnibus de dérivation de courant,
que des couches électriquement conductrices sont générées sur la totalité d'une matrice de cellules solaires composée de plusieurs cellules solaires (1) se chevauchant sur divers ou plusieurs (nombreux) points de commutation (22) par sérigraphie, dispersion, pulvérisation, vaporisation, pulvérisation cathodique ou par séparation galvanique, ou
que du matériau de contact (10) est placé et fixé sur la totalité de la matrice de cellules solaires sur les points de commutation (22),
dans lequel et laquelle l'interconnexion des cellules solaires (1) se chevauchant a lieu seulement sur le côté avant (18) ou seulement sur le côté arrière (19) des cellules solaires ou entre les côtés frontaux (20) ou entre un ou plusieurs côtés frontaux (20) et un côté avant ou un côté arrière (18, 19) ou sur et/ou dans une ouverture (21) et un côté avant ou côté arrière (18, 19).

10. Procédé d'interconnexion de cellules solaires rigides ou flexibles planes selon la revendication 9,
dans lequel des couches électriquement conductrices sont générées simultanément lors d'une étape de travail unique sur la totalité d'une matrice de cellules solaires composée de plusieurs cellules solaires (1) se chevauchant sur les points de commutation (22) par sérigraphie, dispersion, pulvérisation, vaporisation, pulvérisation cathodique ou par séparation galvanique, ou
que les matériaux de contact (10) sont placés et fixés simultanément lors d'une étape de travail unique sur la totalité de la matrice de cellules solaires sur les points de commutation (22).

11. Procédé d'interconnexion de cellules solaires rigides ou flexibles planes selon la revendication 9,
dans lequel des couches électriquement conductrices sont générées sur la totalité de la matrice de cellules solaires composée de plusieurs cellules solaires (1) se chevauchant sur les points de commutation (22) à l'aide d'une combinaison de deux procédés, par exemple par sérigraphie et/ou dispersion et/ou pulvérisation et/ou vaporisation et/ou pulvérisation cathodique et/ou séparation galvanique, les matériaux de contact (10) sont placés et fixés sur la totalité de la matrice de cellules sur les points de commutation (22).

12. Procédé d'interconnexion de cellules solaires rigides ou flexibles planes selon la revendication 9,
dans lequel une métallisation totale de la matrice de cellules du module solaire (des barres omnibus, des doigts de contact et de l'interconnexion) a lieu après l'agencement et la fixation des cellules solaires (1) se chevauchant sur le matériau de support (2) simultanément lors d'une étape de procédé.

13. Procédé d'interconnexion de cellules solaires rigides ou flexibles planes selon l'une quelconque des revendications 9 à 12,
dans lequel
le matériau de contact (10) pour interconnecter les cellules solaires (1) se chevauchant entre elles est le même matériau que le matériau pour la métallisation de cellules solaires.
